# EUROPÄISCHE PATENTSCHRIFT

(11) **EP 0 563 421 B1**
(45) Veröffentlichungstag und Bekanntmachung des Hinweises auf die Patenterteilung: **04.06.1997**
(21) Anmeldenummer: 92105549.7
(22) Anmeldetag: 31.03.1992
(51) Int. Cl.: H03F 3/217, H03G 3/00

(54) **Schaltungsanordnung mit einem Schaltverstärker**
Circuit arrangement with a switch amplifier
Arrangement de circuit à amplificateur de commutation

(43) Veröffentlichungstag der Anmeldung: 06.10.1993
(73) Patentinhaber: Siemens Audiologische Technik GmbH, 91058 Erlangen (DE)
(72) Erfinder: Pfannenmüller, Gerhard, W-8507 Oberasbach (DE); Martin, Raimund, Dipl.-Ing., W-8557 Eggolsheim (DE)
(74) Vertreter: Fuchs, Franz-Josef, Dr.-Ing.

(56) Entgegenhaltungen:
- EP-A- 0 079 559
- EP-A- 0 326 742
- EP-A- 0 503 571
- DE-A- 1 942 726
- PATENT ABSTRACTS OF JAPAN vol. 14, no. 437 (E-980)19. September 1990 & JP-A-21 70 617

## Beschreibung

Die vorliegende Erfindung bezieht sich auf eine Hörgeräte-Schaltungsanordnung mit einem Schaltverstärker und zur Begrenzung eines pulsdauermodulierten Signals, das aus einem niederfrequenten Signal und aus einem höherfrequenten Dreiecksignal gebildet ist.

Aus der DE-PS 36 16 752 ist eine Schaltungsanordnung mit einem Schaltverstärker für Hörgeräte bekannt. In dieser bekannten Schaltungsanordnung wird ein pulsdauermoduliertes (pulsweitenmoduliertes) Signal aus einem niederfrequenten Audiosignal und aus einem höherfrequenten Dreiecksignal in einem Pulsdauermodulator gebildet. Nach Verstärkung des pulsdauermodulierten Signals in dem Schaltverstärker wird aus der unterschiedlichen Dauer der Einzelimpulse des pulsdauermodulierten Signals das Audiosignal detektiert. Das geschieht in Hörgeräten üblicherweise durch die Tiefpaßwirkung eines am Ausgang des Schaltverstärkers angeschlossenen Hörers.

Bei einem pulsdauermodulierten Signal ist die Amplitude des Audiosignales (Nutzsignales) in der Dauer (Breite/Weite) der Einzelimpulse des den Schaltverstärker steuernden pulsdauermodulierten Signals kodiert. Daher ist die Amplitude des in der Pulsdauer kodierten Nutzsignales mit üblichen Verfahren oder Clipschaltungen nicht in der Endstufe (in dem Schaltverstärker) begrenzbar.

Man hat daher schon das Audiosignal (Nutzsignal) in einer Vorstufe in der Amplitude begrenzt und mit diesem vorab begrenzten Audiosignal eine Pulsdauermodulation erzeugt. Dadurch entsteht aber eine unerwünschte spektrale Verbreiterung des Nutzsignals schon vor dem Pulsdauermodulator, was zu unerwünscht hohen Rückfaltungsprodukten (hohe Verzerrungen) im Ausgangssignal führt.

Um diesen Nachteil zu vermeiden, hat man schon die Betriebsspannung (bzw. den Betriebsstrom) für den Schaltverstärker begrenzt. Das führt aber zu einer unerwünschten Verstärkungsund Leistungsverminderung des demodulierten Ausgangssignales.

Der Erfindung liegt die Aufgabe zugrunde, eine Schaltungsanordnung der eingangs genannten Art anzugeben, womit ohne Verstärkungsverminderung bei nur geringen Verzerrungen eine Begrenzung des aus dem Schaltverstärker entnehmbaren Ausgangssignales (Nutzsignales) erreicht wird.

Diese Aufgabe wird durch eine Schaltungsanordnung gemäß Anspruch 1 gelöst.

Die Erfindung geht von der Erkenntnis aus, daß die Amplitude des Nutzsignales in jeder Pulsdauer des pulsdauermodulierten Signales enthalten ist. Daher wird erfindungsgemäß eine Schaltungsanordnung angegeben, mit der die Pulsdauer der Einzelimpulse in dem pulsdauermodulierten Signal bei Erreichen eines Maximalwertes und Minimalwertes verändert (vermindert bzw. vergrößert) wird. Mit anderen Worten: Die maximal und minimal mögliche Dauer der Einzelimpulse wird in dem pulsdauermodulierten Signal verändert (begrenzt). Diese erfindungsgemäße Begrenzung (Veränderung) bewirkt, daß das pulsdauermodulierte Signal ohne Verstärkungsverminderung in dem Schaltverstärker verstärkt werden kann, ohne daß vor oder während der Verstärkung in dem Schaltverstärker zusätzliche Verzerrungen in dem niederfrequenten Signal (Nutzsignal) entstehen.

Zur Begrenzung der maximal möglichen Dauer der Einzelimpulse wird das pulsdauermodulierte Signal erfindungsgemäß einer Schaltung, z. B: Torschaltung, zugeführt, die vorzugsweise als Und-Schaltung ausgebildet ist. Mit der Torschaltung wird die maximal zulässige Dauer von Einzelimpulsen vorgegeben. Wenn das pulsdauermodulierte Signal Einzelimpulse aufweist, deren Dauer größer ist als die mit der Torschaltung vorgegebene maximale Dauer, so werden diese Einzelimpulse in der Torschaltung auf die maximal zulässige Dauer begrenzt (vermindert). Mit dem derart begrenzten pulsdauermodulierten Signal wird der Schaltverstärker angesteuert.

In Weiterbildung der Erfindung ist aus dem höherfrequenten Dreiecksignal und aus einer Schwellenspannung mittels einer Vergleichsschaltung ein Rechtecksignal gebildet, das die maximal zulässige Impulsdauer an der Torschaltung festlegt. Das für die Erzeugung des pulsdauermodulierten Signals benutzte Dreicksignal wird sonach erfindungsgemäß auch zur Bildung eines Torimpulses für die Festlegung der maximal zulässigen Impulsdauer benutzt. Dadurch wird ohne aufwendige Schaltungstechnik eine symmetrische Begrenzung der zu begrenzenden Einzelimpulse in dem pulsmodulierten Signal erreicht. Das heißt, jeder begrenzte Einzelimpuls wird - von einer gedachten Mittellinie des Einzelimpulses aus betrachtet, die senkrecht auf einer Zeitachse steht - beidseits in Richtung dieser Zeitachse um jeweils eine etwa gleich große Dauer verkürzt. Durch diese symmetrische Verkürzung (Begrenzung) der Dauer eines Einzelimpulses werden Verzerrungen vermieden oder mindestens deutlich vermindert, die nach der Demodulation des begrenzten niederfrequenten Signales (Nutzsignales) bei unsymmetrischer Begrenzung der Einzelimpulse in dem pulsmodulierten Signal entstehen können.

Weitere Vorteile und Einzelheiten der Erfindung ergeben sich aus der nachfolgenden Beschreibung von Ausführungsbeispielen anhand der Zeichnungen und in Verbindung mit den Ansprüchen.

Es zeigen:
Figur 1 eine Schaltungsanordnung zur erfindungsgemäßen Begrenzung eines pulsdauermodulierten Signales,
Figur 2 eine erfindungsgemäße Schaltungsanordnung zum Begrenzen komplementärer pulsdauermodulierter Signale und
Figur 3 eine Darstellung einiger Signale, die in erfindungsgemäßen Schaltungsanordnungen nach der Figur 1 und/oder nach der Figur 2 auftreten können.

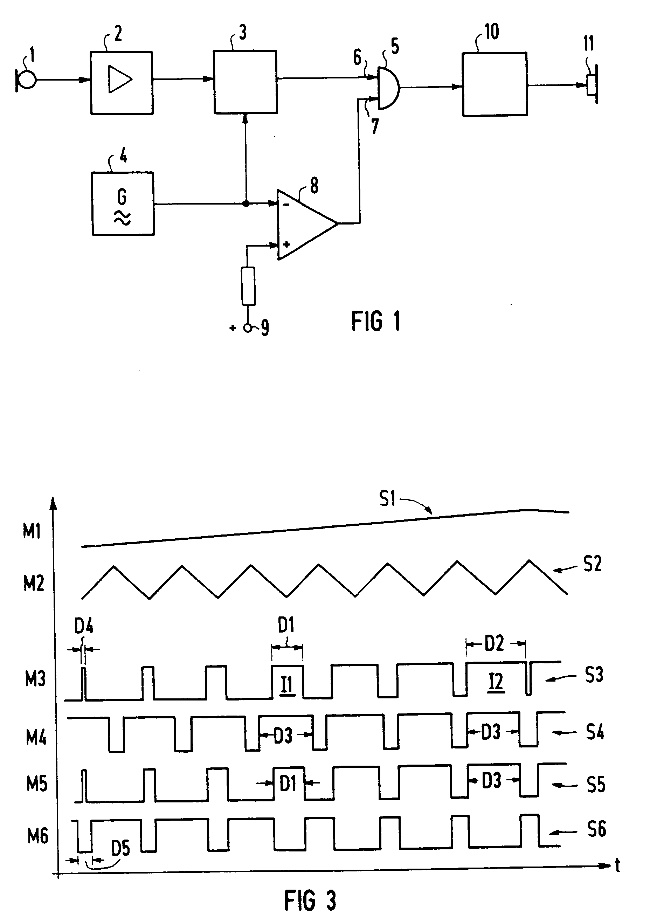

In Figur 1 ist eine prinzipielle Hörgeräteschaltung mit einer Schaltungsanordnung gemäß der Erfindung dargestellt. Ein von einem Mikrofon 1 aufgenommenes Schallsignal wird in ein elektrisches niederfrequentes Signal gewandelt und über einen Verstärker 2 einem Pulsdauermodulator 3 (Pulsweitenmodulator) zugeführt. Dem Pulsdauermodulator 3 wird aus einem Generator 4, der auch nicht dargestellte Pulsformerstufen umfassen kann, ein gegenüber dem Niederfrequenzsignal höherfrequenteres Dreiecksignal zugeführt. Aus dem niederfrequenten Signal und aus dem Dreiecksignal wird in an sich bekannter Weise in dem Pulsdauermodulator 3 ein pulsdauermoduliertes Signal gebildet, das einer Torschaltung 5 über einen ersten Eingang 6 zugeführt wird. Mit der Torschaltung 5 werden Einzelimpulse in dem pulsdauermodulierten Signal in der Dauer begrenzt, sofern deren Dauer größer ist als eine durch die Torschaltung 5 vorgebbare Dauer.

In diesem Ausführungsbeispiel ist die Torschaltung 5 als Und-Schaltung ausgebildet und erhält über einen zweiten Eingang 7 ein Steuersignal. Dieses Steuersignal wird in einer Vergleichsschaltung 8 gebildet. Für die Bildung des Steuersignals wird das von dem Generator 4 gelieferte Dreiecksignal zusätzlich verwendet. Dazu wird das Dreiecksignal mit einer vorgebbaren, z.B. manuell einstellbaren, Schwellenspannung in der Vergleichsschaltung 8 verglichen. Als Vergleichsschaltung eignen sich insbesondere Komparatorschaltungen. Am Ausgang der Vergleichsschaltung 8 steht dann ein rechteckförmiges Steuersignal für die Torschaltung 5 zur Verfügung.

Die Pulsdauer der Einzelimpulse in dem rechteckförmigen Steuersignal kann durch die über einen Anschluß 9 der Vergleichsschaltung 8 zugeführte und einstellbare Schwellenspannung verändert werden. Mit dieser veränderbaren Einstellung der Schwellenspannung wird die Breite (die Dauer, das Tor) für das pulsdauermodulierte Signal in der Torschaltung 5 gesteuert. Folglich ist mit der Schwellenspannung an der Vergleichsschaltung 8 die Größe der Begrenzung der Impulsdauer des pulsmodulierten Signales steuerbar. Die Torschaltung 5 wirkt demnach als Begrenzer. Mit dem durch die Torschaltung 5 begrenzten pulsmodulierten Signal wird ein Schaltverstärker 10 angesteuert, an den in an sich bekannter Weise ein Hörer 11 angeschlossen ist.

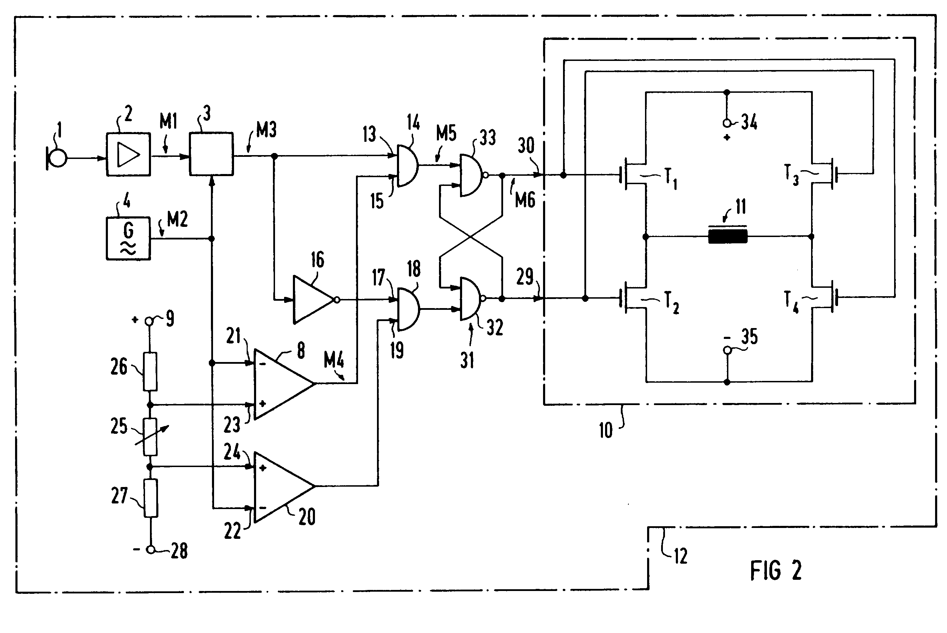

In Figur 2 ist eine Schaltungsanordnung gemäß der Erfindung dargestellt, die neben den in Figur 1 beschriebenen Schaltungsteilen noch weitere Schaltungsteile aufweist und insbesondere für ein symbolisch dargestelltes Hörgerät 12 geeignet ist, dessen Schaltverstärker 10 im Gegentakt arbeitet. Zur Erleichterung des Verständnisses dieser Schaltungsanordnung sind in Figur 3 einige Signale dargestellt, die innerhalb dieser Schaltungsanordnung an den jeweils mit "M" bezeichneten Meßpunkten meßbar sind.

In Figur 2 ist zwischen dem Verstärker 2 und dem Pulsdauermodulator 3 an einem Meßpunkt M1 ein niederfrequentes Signal S1 meßbar, von welchem in Figur 3 ein Ausschnitt mit ansteigender Amplitude dargestellt ist. Der Generator 4 in Figur 2 liefert am Meßpunkt M2 ein in Figur 3 dargestelltes Dreiecksignal S2. Aus der Verarbeitung der Signale S1 und S2 in dem Pulsdauermodulator 3 ergibt sich ein pulsdauermoduliertes Signal S3, das am Meßpunkt M3 am Ausgang des Pulsdauermodulators 3 meßbar ist. Dieses pulsdauermodulierte Signal S3 wird über einen ersten Eingang 13 (Figur 2) einer als erste Und-Schaltung 14 ausgebildeten Torschaltung zugeführt. Der ersten Und-Schaltung 14 wird über einen zweiten Eingang 15 ein Steuersignal aus der Vergleichsschaltung 8 zugeführt, was bereits zu Figur 1 ausführlich beschrieben ist. Das Steuersignal ist rechteckförmig und am Meßpunkt M4 in Figur 2 meßbar und als Rechtecksignal S4 in Figur 3 dargestellt.

Aus Figur 3 ist entnehmbar, daß das pulsdauermodulierte Signal S3 Einzelimpulse, z.B. I1 und I2, mit unterschiedlicher Impulsdauer D1 und D2 aufweist. Bei dem Steuersignal S4 weisen alle Einzelimpulse jeweils die gleiche Impulsdauer D3 auf. Mit der Impulsdauer D3 wird die maximal zulässige Impulsdauer der Einzelimpulse in dem pulsdauermodulierten Signal S3 begrenzt. In Figur 3 ist ein derart begrenztes impulsdauermoduliertes Signal S5 dargestellt. Dieses Signal ist am Meßpunkt M5 am Ausgang der Und-Schaltung 14 (Figur 2) meßbar. Aus dem in Figur 3 dargestellten begrenzten Pulsdauersignal S5 ist entnehmbar, daß der Einzelimpuls I1 in dem Signal S3 die gleiche Dauer D1 hat wie der entsprechende Impuls in dem begrenzten Signal S5. Der Einzelimpuls I1 ist folglich unbegrenzt geblieben. Dagegen ist der Impuls I2 in dem unbegrenzten Signal S3 auf die maximal zulässige Dauer D3 in dem begrenzten Signal S5 begrenzt (zeitlich verkürzt) worden.

In Figur 2 ist die erfindungsgemäße Schaltungsanordnung für Gegentaktbetrieb ausgebildet. Dazu ist das pulsdauermodulierte Signal S3 über einen Inverter 16 als invertiertes Signal einem ersten Eingang 17 einer zweiten als Torschaltung ausgebildeten Und-Schaltung 18 zugeführt. Der zweiten Und-Schaltung 18 wird über einen zweiten Eingang 19 ein Rechtecksignal zugeführt, das ein komplementäres Signal zu dem Rechtecksignal S4 darstellt. Dieses komplementäre Rechtecksignal wird aus einem Vergleich des höherfrequenten Dreiecksignals S2 mit einer anderen Schwellenspannung in einer weiteren Vergleichsschaltung 20 gebildet. Die andere Schwellenspannung ist dabei komplementär zu der Schwellenspannung an der Vergleichsschaltung 8 eingestellt. Dadurch entsteht der wesentliche Vorteil, daß das demodulierte Niederfrequenzsignal symmetrisch begrenzt wird, d.h. bezogen auf einen Mittelwert (Symmetrielinie) werden die positiven und negativen Amplituden ab dem gleichen Betrag begrenzt. Folglich werden die Verzerrungen durch diese symmetrische Begrenzung nochmals vermindert.

In Ausbildung der Erfindung sind die beiden Vergleichsschaltungen 8 und 20 als Komparatorschaltungen ausgebildet, deren invertierenden Eingängen 21 und 22 die Dreieckspannung (das Dreiecksignal) S2 zugeführt ist. Ein nichtinvertierender Eingang 23 an der Vergleichsschaltung 8 und ein nichtinvertierender Eingang 24 sind über ein Stellglied 25, z.B. Potentiometer, miteinander verbunden. Dabei sind die über das Stellglied 25 verbundenen Eingänge 23 und 24 an je einen Pol (plus bzw. minus) der Schaltungsanordnung angekoppelt. In der Schaltungsanordnung gemäß Figur 2 geschieht die Ankopplung zum Pluspol über einen Widerstand 26 und den Anschluß 9. Die Ankopplung zum Minuspol erfolgt über einen Widerstand 27 und ei nen Anschluß 28. Die Widerstände 26 und 27 können so auf das Stellglied 25 abgestimmt sein, daß die Begrenzung des pulsmodulierten Signals mit dem Stellglied 25 ein- und ausschaltbar ist. Das Stellglied 25 kann auch als digital einstellbares und/oder programmierbares Stellglied ausgebildet sein.

Am Ausgang der Und-Schaltung 18 steht im Ergebnis ebenfalls ein begrenztes impulsmoduliertes Signal zur Verfügung, bei dem im Gegensatz zu dem begrenzten Signal S5 (Figur 3) die Impulsdauer D4 eines kurzen Einzelimpulses auf einen Minimalwert D5 im Signal S6 vergrößert ist. Die Impulsdauer D5 wird nicht unterschritten, wobei der Minimalwert D5 durch die als Und-Schaltung 18 ausgebildete Torschaltung vorgebbar ist. Mit der Und-Schaltung 18 wird folglich die minimal zulässige Impulsdauer der Einzelimpulse in dem zu dem Signal S3 komplementären pulsdauermodulierten Signal begrenzt. Die so erzeugten begrenzten und pulsdauermodulierten Gegentaktsignale stehen ausgangsseitig an den Und-Schaltungen 14 und 18 zur Ankopplung an einen Eingang 29 bzw. 30 des Schaltverstärkers 10 zur Verfügung.

In Ausbildung der Erfindung ist eine Flip-Flop-Schaltung 31 mit den beiden Kippstufen 32 und 33 zur Ankopplung der Und-Schaltungen 14 und 19 an den Schaltverstärker 10 vorgesehen.

Mit dieser Flip-Flop-Schaltung 31 wird im Falle einer Begrenzung der Impulsdauer eine Symmetrierung der beiden Signale an den Eingängen 29 und 30 des Schaltverstärkers 10 erzwungen. Dadurch können Verzerrungen nochmals vermindert werden. In Figur 3 ist ein derart begrenztes und symmetriertes pulsdauermoduliertes Signal S6 dargestellt, das in Figur 2 am Meßpunkt M6 meßbar ist.

Der Schaltverstärker 10 weist in Figur 2 vier im Schaltbetrieb arbeitende MOS-FET-Transistoren T1 bis T4 auf. Die Transistoren T1 und T2 sowie die Transistoren T3 und T4 sind jeweils komplementär zueinander ausgebildet. Der Schaltverstärker 10 wird über Anschlüsse 34 und 35 mit Betriebsspannung versorgt. Durch den Schaltbetrieb sind entweder die Transistoren T1 und T4 oder T3 und T2 gleichzeitig leitend. Der Zeitraum, innerhalb welchem diese Transistoren leitend sind, wird von der jeweiligen Impulsdauer eines jeden Impulses in dem über die Eingänge 29 und 30 des Schaltverstärkers zugeführten begrenzten impulsmodulierten Signal gesteuert. Bei einem Wechsel des Pegels in dem pulsmodulierten Signal wechseln folglich auch die leitend geschalteten Transistoren in den nicht leitenden Zustand und die bisher nicht leitenden Transistoren werden sodann leitend. Im Ergebnis wird folglich der in dem Brückenzweig des Schaltverstärkers 10 angeordnete Hörer 11 zwischen der an den Anschlüssen 34 und 35 liegenden Betriebsspannung (Plus- und Minuspol) umgeschaltet. Die Begrenzung entsteht durch die Verkürzung eines beispielsweise ursprünglich langen Einzelimpulses mit der Dauer D2 auf eine Dauer D3 (vergleiche dazu die Signale S3 und S5 in Figur 3). Durch einen derart verkürzten Einzelimpuls kann sich der Strom bzw. die Spannung an dem Hörer 11 nicht mehr in voller Höhe ausbilden. Dadurch erscheint das durch den Hörer 11 wiedergegebene niederfrequente Signal als ein in der Amplitude begrenztes Signal.

Durch die hier vorliegende digitale Begrenzung eines NF-Signals entsteht kein zusätzliches Rauschen, die Pegel sind reproduzierbar, digital programmier- und lesbar. Die Schaltung hat einen günstigeren Wirkungsgrad als bekannte Vorstufenbegrenzungsschaltungen. Die erfindungsgemäße Schaltungsanordnung ist durch ihre Bauweise auch als integrierter Schaltkreis oder als Bestandteil eines integrierten Schaltkreises ausbildbar. Von Vorteil ist auch, daß für kleine Amplituden kein Verstärkungsverlust entsteht. Durch eine einfache Zusatzschaltung kann außerdem ein digitales Anzeigesignal abgeleitet werden, das das Ansprechen der Begrenzung(Clipwirkung) anzeigt.

## Patentansprüche

1. Hörgeräte-Schaltungsanordnung mit einem Schaltverstärker (10) und zur Begrenzung eines pulsdauermodulierten Signals (S3), das aus einem niederfrequenten Signal (S1) und aus einem höherfrequenten Dreiecksignal (S2) gebildet ist, wobei das pulsdauermodulierte Signal (S3) einer Schaltung (5; 14; 18) zugeführt ist, durch welche die maximal und minimal mögliche Dauer (D3 bzw. D5) der Einzelimpulse in dem pulsdauermodulierten Signal begrenzbar ist, wobei die Schaltung in dem pulsdauermodulierten Signal (S3) die Dauer (D1, D2) von Einzelimpulsen vermindert, deren Dauer (D1, D2) größer als eine durch die Schaltung (5; 14; 18) vorgebbare maximale Impulsdauer (D3) ist, wobei das durch die Schaltung (5; 14, 18) veränderte pulsdauermodulierte Signal (S5, S6) dem Schaltverstärker (10) als Eingangssignal zuführbar ist, und wobei ferner die Schaltung in dem pulsdauermodulierten Signal (S3) die Dauer (D4) von Einzelimpulsen vergrößert, deren Dauer (D4) kleiner als eine durch die Schaltung (5; 14; 18) vorgebbare minimale Impulsdauer (D5) ist, wobei das durch die Schaltung (5; 14; 18) veränderte pulsdauermodulierte Signal (S6) dem Schaltverstärker (10) als Eingangssignal zuführbar ist.

2. Hörgeräte-Schaltungsanordnung nach Anspruch 1, wobei aus dem höherfrequenten Dreiecksignal (S2) ein Steuersignal (S4) für die Schaltung (5; 14, 18) gebildet ist und wobei die Schaltung aus einer Torschaltung besteht.

3. Hörgeräte-Schaltungsanordnung nach Anspruch 1 oder 2, wobei das pulsdauermodulierte Signal (S3) einem ersten Eingang (13) einer ersten die Schaltung bildenden Und-Schaltung (14) zugeführt ist und wobei aus dem höherfrequenten Dreiecksignal (S2) und aus einer Schwellenspannung mittels einer Vergleichsschaltung (8) ein Rechtecksignal (S4) gebildet ist, das einem zweiten Eingang (15) der ersten Und-Schaltung (14) zugeführt ist, die ausgangsseitig an einen Eingang (30) des Schaltverstärkers (10) angekoppelt ist.

4. Hörgeräte-Schaltungsanordnung nach Anspruch 1 oder 2, wobei das pulsdauermodulierte Signal (S3) als invertiertes Signal einem ersten Eingang (17) einer zweiten die Schaltung bildenden Und-Schaltung (18) zugeführt ist und wobei aus dem höherfrequenten Dreiecksignal (S2) und aus einer anderen Schwellenspannung mittels einer weiteren Vergleichsschaltung (20) ein anderes Rechtecksignal gebildet ist, das einem zweiten Eingang (19) der zweiten Und-Schaltung (18) zugeführt ist, die ausgangsseitig an einen anderen Eingang (29) des Schaltverstärkers (10) angekoppelt ist.

5. Hörgeräte-Schaltungsanordnung nach einem der Ansprüche 3 oder 4, wobei die Und-Schaltung (14, 18) über eine Flip-Flop-Schaltung (31) an den Schaltverstärker (10) angekoppelt ist.

6. Hörgeräte-Schaltungsanordnung nach einem der Ansprüche 3 bis 5, wobei die Vergleichsschaltung (8, 20) eine Komparatorschaltung ist, deren invertierendem Eingang (21, 22) die Dreieckspannung (S2) und deren nichtinvertierendem Eingang die Schwellenspannung zugeführt ist.

7. Hörgeräte-Schaltungsanordnung nach einem der Ansprüche 3 bis 6, wobei die Schwellenspannung über ein vorzugsweise digital programmierbares Stellglied (25) der Vergleichsschaltung (8, 20) zugeführt ist.

8. Hörgeräte-Schaltungsanordnung nach Anspruch 7, wobei über das Stellglied (25) ein Eingang (23) der einen Vergleichsschaltung (8) mit einem Eingang (24) der anderen Vergleichsschaltung (20) verbunden ist und wobei die über das Stellglied (25) verbundenen Eingänge (23, 24) der Vergleichsschaltugen (8, 20) an je einen Pol einer Betriebsspannung der Schaltungsanordnung angekoppelt sind.

9. Hörgeräte-Schaltungsanordnung nach einem der Ansprüche 1 bis 8, wobei die Schaltungsanordnung als integrierter Schaltkreis ausgebildet oder Bestandteil eines integrierten Schaltkreises ist.

## Claims

1. Hearing-aid circuit arrangement having a switching amplifier (10) and for limiting a pulse-duration-modulated signal (S3), which is formed from a low-frequency signal (S1) and from a higher-frequency delta signal (S2), with the pulse-duration-modulated signal (S3) being supplied to a circuit (5; 14; 18), by means of which the maximum and minium possible duration (D3 and D5) of the individual pulses in the pulse-duration-modulated signal can be limited, with the circuit in the pulse-duration-modulated signal (S3) reducing the duration (D1, D2) of individual pulses, the duration (D1, D2) of which is longer than a maximum pulse duration (D3) specifiable by the circuit (5; 14; 18), with the pulse-duration-modulated signal (S5, S6) which is changed by the circuit (5; 14, 18) being capable of being supplied to the switching amplifier (10) as input signal, and with, moreover, the circuit in the pulse-duration-modulated signal (S3) increasing the duration (D4) of individual pulses, the duration (D4) of which is shorter than a minimum pulse duration (D5) specifiable by the circuit (5; 14; 18), with the pulse-duration-modulated signal (S6) which is changed by the circuit (5; 14; 18) being capable of being supplied to the switching amplifier (10) as input signal.

2. Hearing-aid circuit arrangement according to claim 1, with a control signal (S4) for the circuit (5; 14; 18) being formed from the higher-frequency delta signal (S2) and with the circuit comprising a gate circuit.

3. Hearing-aid circuit arrangement according to claim 1 or 2, with the pulse-duration-modulated signal (S3) being supplied to a first input (13) of a first AND circuit (14) forming the circuit, and with a square wave signal (S4) being formed from the higher-frequency delta signal (S2) and from a threshold voltage by means of a reference circuit (8), which square wave signal is supplied to a second input (15) of the first AND circuit (14), which is coupled on the output side to an input (30) of the switching amplifier (10).

4. Hearing-aid circuit arrangement according to claim 1 or 2, with the pulse-duration-modulated signal (S3) being supplied as inverted signal to a first input (17) of a second AND circuit (18) forming the circuit, and with another square wave signal being formed from the higher-frequency delta signal (S2) and from another threshold voltage by means of a further reference circuit (20), which square wave signal is supplied to a second input (19) of the second AND circuit (18) which is coupled on the output side to another input (29) of the switching amplifier (10).

5. Hearing-aid circuit arrangement according to one of claims 3 or 4, with the AND circuit (14, 18) being coupled by way of a flip-flop circuit (31) to the switching amplifier (10).

6. Hearing-aid circuit arrangement according to one of claims 3 to 5, with the reference circuit (8, 20) being a comparator circuit, to the inverting input (21, 22) of which the delta voltage (S2) is supplied and to the non-inverting input of which the threshold voltage is supplied.

7. Hearing-aid circuit arrangement according to one of claims 3 to 6, with the threshold voltage being supplied by way of a preferably digitally programmable actuator (25) to the reference circuit (8, 20).

8. Hearing-aid circuit arrangement according to claim 7, with an input (23) of the one reference circuit (8) being connected to an input (24) of the other reference circuit (20) by way of the actuator (25), and with the inputs (23, 24) of the reference circuits (8, 20) which are connected by way of the actuator (25) being coupled to a respective pole of an operating voltage of the circuit arrangement.

9. Hearing-aid circuit arrangement according to one of claims 1 to 8, with the circuit arrangement being formed as an integrated switching circuit or being a component of an integrated switching circuit.

## Revendications

1. Montage pour appareil de correction auditive, comportant un amplificateur (10) de commutation destiné à limiter un signal (S3) modulé en durée d'impulsion, qui est formé d'un signal (S1) basse fréquence et d'un signal (S2) triangulaire de fréquence plus haute, le signal (S3) modulé en durée d'impulsion étant envoyé à un circuit (5 ; 14; 18), par lequel la durée maximum et minimum possible (D3 ou D5) des impulsions individuelles dans le signal modulé en durée d'impulsion peut être limitée, le circuit diminuant, dans le signal (S3) modulé en durée d'impulsion, la durée (D1, D2) d'impulsions individuelles, dont la durée (D1, D2) est plus grande qu'une durée (D3) d'impulsion maximum pouvant être prescrite par le circuit (5 ; 14 ; 18), le signal (S5, S6) modulé en durée d'impulsion et modifié par le circuit (5 ; 14 ; 18) pouvant être envoyé à l'amplificateur (10) de commutation comme signal d'entrée, le circuit augmentant en outre dans le signal (S3) modulé en durée d'impulsion la durée (D4) d'impulsions individuelles, dont la durée (D4) est plus petite qu'une durée (D5) d'impulsion minimum pouvant être prescrite par le circuit (5 ; 14 ; 18), le signal (S6) modulé en durée d'impulsion et modifié par le circuit (5 ; 14 ; 18) pouvant être envoyé à l'amplificateur (10) de commutation comme signal d'entrée.

2. Montage pour appareil de correction auditive suivant la revendication 1, dans lequel un signal de commande (S4) pour le circuit (5 ; 14 ; 18) est formé à partir du signal (S2) triangulaire de fréquence plus grande et le circuit étant constitué d'un circuit combinatoire.

3. Montage pour appareil de correction auditive suivant la revendication 1 ou 2, dans lequel le signal (S3) modulé en durée d'impulsion est envoyé à une première entrée (13) d'un premier circuit ET (14) formant le circuit et un signal rectangulaire (S4), qui est envoyé à une seconde entrée (15) du premier circuit ET (14) lequel est couplé en sortie à une entrée (30) de l'amplificateur (10) de commutation, est formé au moyen d'un circuit (8) de comparaison à partir du signal triangulaire (S2) de fréquence plus grande et à partir d'une tension de seuil.

4. Montage pour appareil de correction auditive suivant la revendication 1 ou 2, dans lequel le signal (S3) modulé en durée d'impulsion est envoyé comme signal inversé à une première entrée (17) d'un second circuit ET (18) formant le circuit et un autre signal rectangulaire, qui est envoyé à une seconde entrée (19) du second circuit ET (18), lequel est couplé en sortie à une autre entrée (29) de l'amplificateur (10) de commutation, est formé à partir du signal triangulaire (S2) de fréquence plus grande et à partir d'une autre tension de seuil au moyen d'un autre circuit (20) de comparaison.

5. Montage pour appareil de correction auditive suivant l'une des revendications 3 ou 4, dans lequel le circuit ET (14, 18) est couplé par l'intermédiaire d'un circuit (31) de bascule bistable à l'amplificateur (10) de commutation.

6. Montage pour appareil de correction auditive suivant l'une des revendications 3 à 5, dans lequel le circuit (8, 20) de comparaison est un circuit comparateur, à l'entrée inverseuse (21, 22) duquel est envoyée la tension triangulaire (S2) et à l'entrée non inverseuse duquel est envoyée la tension de seuil.

7. Montage pour appareil de correction auditive suivant l'une des revendications 3 à 6, dans lequel la tension de seuil est envoyée par l'intermédiaire d'un élément (25) de réglage programmable de préférence numériquement au circuit (8, 20) de comparaison.

8. Montage pour appareil de correction auditive suivant la revendication 7, dans lequel une entrée (23) de l'un (8) des circuits comparateurs est reliée par l'intermédiaire de l'élément (25) de réglage à une entrée (24) de l'autre circuit (20) de comparaison et les entrées (23, 24) des circuits (8, 20) de comparaison, qui sont reliées par l'intermédiaire de l'élément (25) de réglage, sont couplées chacune à un pôle d'une tension de fonctionnement du montage.

9. Montage pour appareil de correction auditive suivant l'une des revendications 1 à 8, dans lequel le montage est sous forme de circuit intégré ou fait partie d'un circuit intégré.
